# EUROPEAN PATENT APPLICATION

(11) **EP 4 549 899 A1**
(43) Date of publication of application: **07.05.2025**
(21) Application number: 23872044.5
(22) Date of filing: 19.09.2023
(51) Int. Cl.: G01L 1/14, B62D 1/06

(54) **CONTACT DETECTION DEVICE**

(30) Priority: 30.09.2022 JP 2022158512
(71) Applicant: Sumitomo Riko Company Limited, Komaki-shi, Aichi 485-8550 (JP)
(72) Inventor: YOSHIDA Satoshi, Komaki-shi, Aichi 485-8550 (JP); SUGIYAMA Takami, Komaki-shi, Aichi 485-8550 (JP); TSUNAKI Ichiro, Komaki-shi, Aichi 485-8550 (JP); MAEDA Takuma, Komaki-shi, Aichi 485-8550 (JP)
(74) Representative: Becker, Eberhard
(86) International application number: PCT/JP2023/033933
(87) International publication number: WO 2024/070816

(57) **Abstract**

A contact detection device (10) comprises a capacitive sensor (7), and a determination processor (30) that detects whether a conductive body has come into contact with a plurality of detection regions (LF, RF, LB, RB). The determination processor (30) comprises a storage unit (31), a determination reference value setting unit (32), and a determination processing unit (33). The determination reference value setting unit (32) determines that a detection region in which the difference between a capacitance-corresponding value and a setting reference value (41) surpasses a threshold value (43) is a contact region with which the conductive body is in contact, determines that a detection region in which the difference between the capacitance-corresponding value and the setting reference value (41) is less than or equal to the threshold value (43) is a non-contact region with which the conductive body is not in contact, and upon determining that there is a contact region and determining that there is a non-contact region, sets the setting reference value (41) corresponding to the non-contact region as a contact region determination reference value (42) for the contact region.

## Description

### Technical Field

The present invention relates to a contact detection apparatus.

### Related Art

Conventionally, an information input device using a grip sensor that detects contact with a human body by a change in capacitance has been proposed in, for example, Patent Document 1.

In this Patent Document 1, an information input interface to which the information from a driver is input is disposed on the curved surface of the grip of the steering wheel, on both the left and right sides as viewed from the driver. The information input interface is composed of, for example, an electrode group in an exclusive region and an electrode group in an input region. These electrode groups are disposed to be insulated from each other. When the driver's hand touches any of the electrode groups, these electrode groups can respectively measure the amount of change in capacitance independently. With this information input device, it is possible to detect the contact of the driver's hand based on the amount of change in the measured capacitance.

### Citation List

### Patent Document

[Patent Document 1] Japanese Patent No. 4676408

### SUMMARY OF INVENTION

### Technical Problem

For the conventional information input device described above, in order to measure the amount of change in capacitance caused by the human body contacting the grip, the value measured in a state where no hand touches the grip is stored as a reference value, and the reference value is subtracted from the measured value. However, for example, if the information input device is started with a hand touching the information input interface on the left side, the value measured in the state where the hand is touching the grip is determined as the initial reference value. If the initial reference value is the value measured in a state where a human hand is touching the grip, there is a problem that the human contact cannot be detected accurately.

The disclosure has been made in view of the above background, and provides a contact detection apparatus that is capable of accurately detecting contact of a conductor even in a state where the conductor is in contact at the time of startup.

### Solution to Problem

One aspect of the disclosure provides a contact detection apparatus, including:
an electrostatic sensor having a plurality of detection regions with which a conductor comes into contact; and
a determination processor detecting whether the conductor is in contact with the plurality of detection regions based on a capacitance equivalent value of each of the plurality of detection regions detected by the electrostatic sensor, in which
the determination processor includes:
   a storage unit storing a setting reference value which is a capacitance equivalent value corresponding to a state where the conductor is not in contact with each of the plurality of detection regions, a determination reference value of each of the plurality of detection regions, and a threshold value commonly or individually associated with each of the plurality of detection regions;
   a determination reference value setting unit setting the determination reference value of each of the plurality of detection regions by an initial process that is performed after the contact detection apparatus is started; and
   a determination processing unit detecting whether the conductor is in contact by comparing the capacitance equivalent value with the determination reference value in each of the plurality of detection regions after the initial process, in which
the determination reference value setting unit
   determines a detection region in which a difference between the capacitance equivalent value and the setting reference value exceeds the threshold value among the plurality of detection regions as a contact region with which the conductor is in contact,
   determines a detection region in which the difference between the capacitance equivalent value and the setting reference value is equal to or less than the threshold value among the plurality of detection regions as a non-contact region with which the conductor is not in contact, and
   sets the setting reference value corresponding to the non-contact region as the determination reference value of the contact region for the contact region in response to determining that the contact region exists and determining that the non-contact region exists.

### Effects of Invention

According to one aspect of the disclosure, during the initial process, the setting reference value corresponding to the non-contact region is set as the determination reference value of the contact region even if a conductor is in contact with the detection region. Thus, even if a conductor is in contact with the detection region, the contact of the conductor can be accurately detected.

It should be noted that the reference numerals in parentheses in the claims indicate the corresponding relationship with the specific means described in the following embodiments, and are not intended to limit the technical scope of the present invention.

### BRIEF DESCRIPTION OF DRAWINGS

FIG. 1 is a front view showing the steering wheel of the first embodiment.
FIG. 2 is a cross-sectional view taken along the line II-II of FIG. 1.
FIG. 3 is a partially cutaway perspective view showing the electrostatic sensor of the first embodiment.
FIG. 4 is a view showing a state where the skin material is removed from the steering wheel of the first embodiment, wherein (a) is a plan view, (b) is a front view, and (c) is a right side view.
FIG. 5 is a block diagram showing the configuration of the contact detection apparatus of the first embodiment.
FIG. 6 is a plan view showing the setting source priority order when the left front detection region is set as the target detection region in the electrostatic sensor of the first embodiment.
FIG. 7 is a plan view showing the setting source priority order when the left back detection region is set as the target detection region in the electrostatic sensor of the first embodiment.
FIG. 8 is a plan view showing the setting source priority order when the right front detection region is set as the target detection region in the electrostatic sensor of the first embodiment.
FIG. 9 is a plan view showing the setting source priority order when the right back detection region is set as the target detection region in the electrostatic sensor of the first embodiment.
FIG. 10 is a flowchart showing the main flow of the contact detection apparatus of the first embodiment.
FIG. 11 is a flowchart showing the initial process of the contact detection apparatus of the first embodiment.
FIG. 12 is a flowchart showing the determination reference value setting process for the left front detection region of the contact detection apparatus of the first embodiment.
FIG. 13 is a flowchart showing the determination reference value setting process for the left back detection region of the contact detection apparatus of the first embodiment.
FIG. 14 is a flowchart showing the determination reference value setting process for the right front detection region of the contact detection apparatus of the first embodiment.
FIG. 15 is a flowchart showing the determination reference value setting process for the right back detection region of the contact detection apparatus of the first embodiment.
FIG. 16 is a flowchart showing the determination process of the contact detection apparatus of the first embodiment.
FIG. 17 is a flowchart showing the update process of the contact detection apparatus of the first embodiment.
FIG. 18 is a flowchart of the setting reference value update process for the left front detection region of the contact detection apparatus of the first embodiment.
FIG. 19 is a flowchart of the setting reference value update process for the left back detection region of the contact detection apparatus of the first embodiment.
FIG. 20 is a flowchart of the setting reference value update process for the right front detection region of the contact detection apparatus of the first embodiment.
FIG. 21 is a flowchart of the setting reference value update process for the right back detection region of the contact detection apparatus of the first embodiment.
FIG. 22 is a plan view showing the setting source priority order when the left front detection region is set as the target detection region in the electrostatic sensor of the second embodiment.
FIG. 23 is a plan view showing the first in the setting source priority order when the left front detection region is set as the target detection region in the electrostatic sensor of the third embodiment.

### DESCRIPTION OF EMBODIMENTS

### (First embodiment)

### 1. Configuration of the steering wheel 1

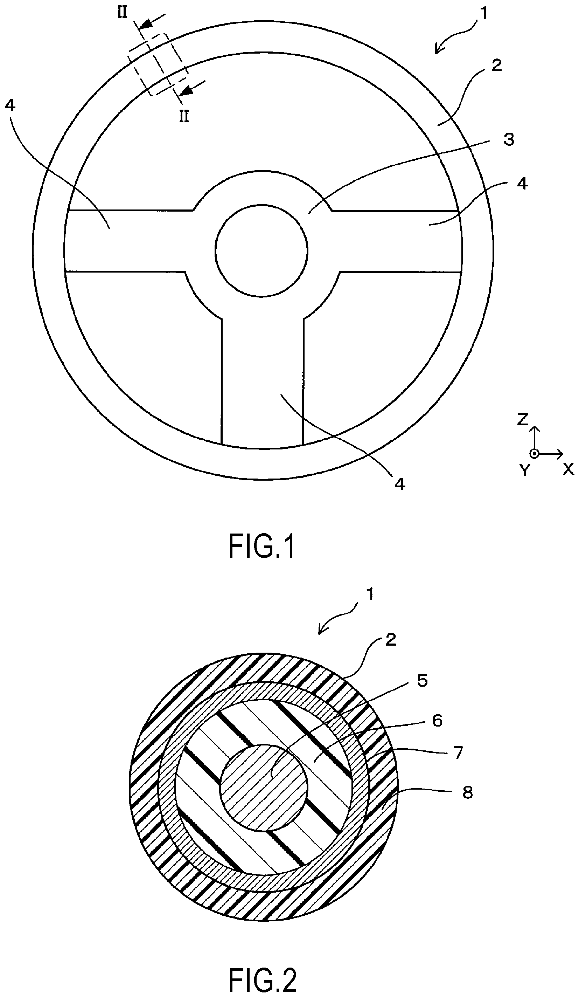

The first embodiment in which a contact detection apparatus 10 according to the disclosure is applied to a steering wheel 1 of a vehicle (not shown) will be described. First, the structure of the steering wheel 1 will be described with reference to FIG. 1 to FIG. 2. As shown in FIG. 1, the steering wheel 1 includes a ring portion 2 formed in a circular ring shape, a core portion 3 formed smaller than the ring portion 2 and disposed radially inside the ring portion 2, and a plurality of connection portions 4 (three in this embodiment) connecting the core portion 3 and the ring portion 2. However, the number of connection portions 4 is not particularly limited, and may be one or two, or four or more.

In the following description, the direction to the right as viewed from a driver (not shown) in the vehicle (not shown) is the direction indicated by arrow X, the direction upward as viewed from the driver is the direction indicated by arrow Z, and the direction approaching the front of the driver is the direction indicated by arrow Y.

As shown in FIG. 2, the ring portion 2 includes a core body 5, a resin inner layer material 6, an electrostatic sensor 7, and a skin material 8. The core body 5 constitutes the central portion of the ring portion 2 and is formed in a shape corresponding to the shape of the ring portion 2. That is, the core body 5 is formed in a circular ring shape and has a circular cross section perpendicular to the axis. Here, the cross-sectional shape of the core body 5 perpendicular to the axis is not limited to a circular shape, but may be any shape such as an elliptical shape, an egg shape, a U-shape, a C-shape, or a polygonal shape. The core body 5 in this embodiment is made of metal such as aluminum or magnesium, and has electrical conductivity. The material of the core body 5 can be a material other than metal.

The resin inner layer material 6 covers the outer surface of the core body 5 over the entire circumference of the ring shape of the core body 5 and over the entire circumference of the circular cross-sectional shape of the core body 5. In this embodiment, the cross section of the resin inner layer material 6 perpendicular to the axis is formed in a circular shape. If the core body 5 has a U-shaped cross section perpendicular to the axis, the resin inner layer material 6 is filled not only on the radial outside of the cross section of the core body 5 perpendicular to the axis, but also in the U-shaped recess of the core body 5. The resin inner layer material 6 is molded on the outer surface side of the core body 5 by injection molding, and is directly bonded to the outer surface of the core body 5. The cross-sectional shape of the resin inner layer material 6 perpendicular to the axis is not limited to a circular shape, but may be any shape such as an egg shape, an elliptical shape, or a polygonal shape. Foamed urethane resin, for example, is used as the resin inner layer material 6. However, it is also possible to use non-foamed resin as the resin inner layer material 6.

The electrostatic sensor 7 is disposed on the outer surface of the resin inner layer material 6. The electrostatic sensor 7 is configured so that when a conductor (not shown) such as a finger or a hand comes into contact with or approaches the electrostatic sensor 7, a capacitance equivalent value of the electrostatic sensor 7 changes. The electrostatic sensor 7 according to this embodiment is a steering wheel sensor that is applied to the steering wheel 1 of the vehicle. The electrostatic sensor 7 will be described in detail later.

The skin material 8 covers the outer surface of the electrostatic sensor 7 (the surface of the electrostatic sensor 7 on the side opposite to the resin inner layer material 6) over the entire circumference of the electrostatic sensor 7. In other words, as described below, in the case where a first electrode layer 22 is exposed on the first surface 24 side of an insulating sheet 21, the skin material 8 also functions as a covering material of the first electrode layer 22. The skin material 8 is molded by injection molding, and is wrapped on the outer surface side of the electrostatic sensor 7 and bonded to the outer surface of the electrostatic sensor 7. The skin material 8 is made of, for example, urethane resin. The outer surface of the skin material 8 constitutes a design surface. Thus, it is preferable to use non-foamed urethane resin or slightly foamed urethane resin as the skin material 8.

### 2. Overall configuration of the electrostatic sensor 7

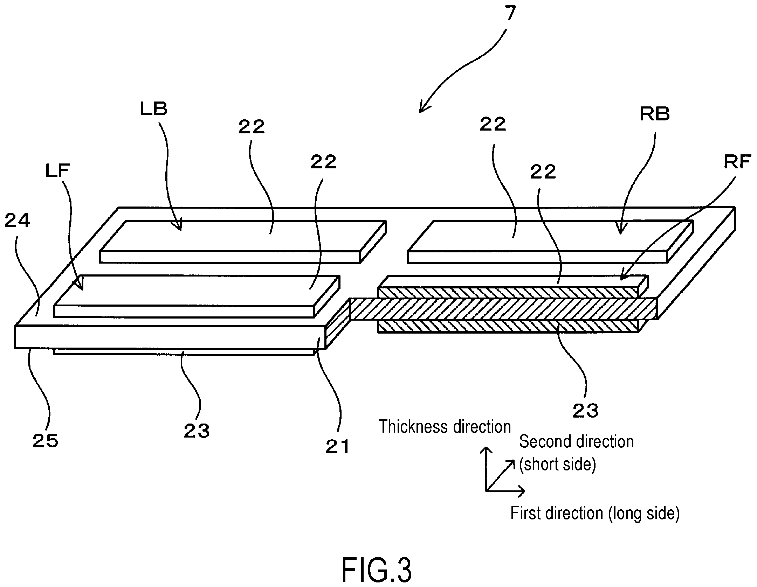

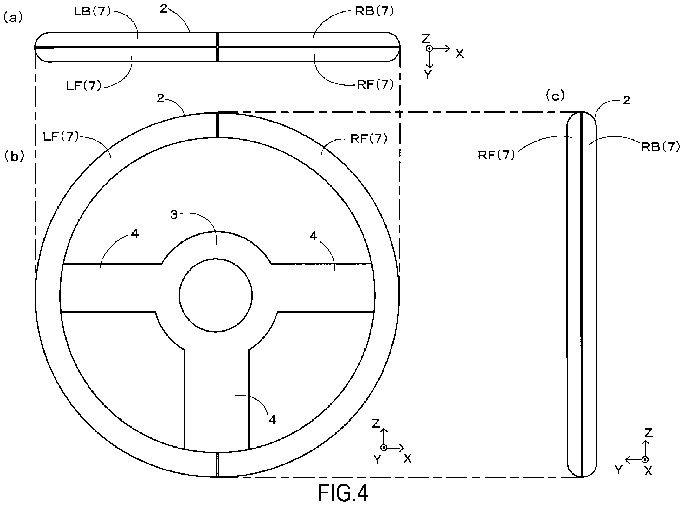

The overall configuration of the electrostatic sensor 7 of the first embodiment will be described with reference to FIG. 3 and FIG. 4. FIG. 3 shows the electrostatic sensor 7 in a state before the electrostatic sensor 7 is wrapped around the steering wheel 1. As shown in FIG. 3, the electrostatic sensor 7 includes the insulating sheet 21, a left front detection region LF, a left back detection region LB, a right front detection region RF, and a right back detection region RB. The insulating sheet 21 is formed in a strip shape extending long and thin in the long side direction, and is formed to be short in the short side direction.

The left front detection region LF, the left back detection region LB, the right front detection region RF, and the right back detection region RB are arranged on a first surface 24 and a second surface 25 of the insulating sheet 21. The left front detection region LF, the left back detection region LB, the right front detection region RF, and the right back detection region RB are formed in a strip shape extending long and thin in the long side direction of the insulating sheet 21, and are formed to be short in the short side direction. The long side direction of the insulating sheet 21 is an example of the first direction, and the short side direction of the insulating sheet 21 is an example of the second direction.

As shown in FIG. 3, the left front detection region LF and the right front detection region RF are arranged to be spaced apart in the long side direction. Further, the left back detection region LB and the right back detection region RB are arranged to be spaced apart in the long side direction.

The left front detection region LF and the left back detection region LB are arranged to be spaced apart in the short side direction. Further, the right front detection region RF and the right back detection region RB are arranged to be spaced apart in the short side direction.

(a) to (c) of FIG. 4 show the steering wheel 1 with the skin material 8 removed. In (a) to (c) of FIG. 4, the electrostatic sensor 7 is wrapped around the surface of the resin inner layer material 6 of the steering wheel 1 (see FIG. 2). As shown in (a) to (c) of FIG. 4, the electrostatic sensor 7 includes a plurality of (four in this embodiment) detection regions LF, RF, LB, and RB. However, the number of detection regions LF, RF, LB, and RB may be one to three, or five or more. Each of the detection regions LF, RF, LB, and RB is formed in a long sheet shape. The electrostatic sensor 7 includes the left front detection region LF disposed on the left front surface side of the resin inner layer material 6, the right front detection region RF disposed on the right front surface side, the left back detection region LB disposed on the left back surface side, and the right back detection region RB disposed on the right back surface side, as viewed from the driver. Each of the detection regions LF, RF, LB, and RB is fixed to the surface of the resin inner layer material 6 of the steering wheel 1 by a known method such as adhesion or thermal fusion.

In a state where the electrostatic sensor 7 is wrapped around the steering wheel 1, the long side direction (first direction) of each of the detection regions LF, RF, LB, and RB is a direction along the central axis of the ring portion 2 of the steering wheel 1, and the short side direction (second direction) of each of the detection regions LF, RF, LB, and RB is a circumferential direction with respect to the axially perpendicular direction of the ring portion 2.

As shown in (a) and (b) of FIG. 4, the left front detection region LF is disposed so as to cover approximately the left half of the front surface side of the resin inner layer material 6 of the steering wheel 1.

As shown in (a) to (c) of FIG. 4, the right front detection region RF is disposed so as to cover approximately the right half of the front surface side of the resin inner layer material 6 of the steering wheel 1.

As shown in (a) and (b) of FIG. 4, the left back detection region LB is disposed so as to cover approximately the left half of the back surface side of the resin inner layer material 6 of the steering wheel 1.

As shown in (a) to (c) of FIG. 4, the right back detection region RB is disposed so as to cover approximately the right half of the back surface side of the resin inner layer material 6 of the steering wheel 1.

In this embodiment, the interval between the left front detection region LF and the right front detection region RF and the interval between the left back detection region LB and the right back detection region RB, which are adjacent in the left-right direction, are larger than the interval between the left front detection region LF and the left back detection region LB and the interval between the right front detection region RF and the right back detection region RB, which are adjacent in the front-back direction.

Returning to FIG. 3, the configuration of each of the detection regions LF, RF, LB, and RB will be described. Each of the detection regions LF, RF, LB, and RB includes a first electrode layer 22 and a second electrode layer 23. The first electrode layer 22 and the second electrode layer 23 have electrical conductivity and formed in a layered shape.

The first electrode layer 22 is laminated on the first surface 24 of the insulating sheet 21. The first electrode layer 22 is formed slightly smaller than the insulating sheet 21 and has a similar shape. Thereby, the edge portion of the first surface 24 of the insulating sheet 21 is exposed from the edge portion of the first electrode layer 22.

The second electrode layer 23 is laminated on the second surface 25 of the insulating sheet 21. The second electrode layer 23 is formed slightly smaller than the insulating sheet 21 and has a similar shape. Thereby, the edge portion of the second surface 25 of the insulating sheet 21 is exposed from the edge portion of the second electrode layer 23.

The first electrode layer 22 and the second electrode layer 23 may be formed in the same shape and size, or may be formed in similar shapes with one being slightly larger than the other.

The insulating sheet 21 is formed to contain, for example, an elastomer as a main component. Therefore, the insulating sheet 21 is flexible. In other words, the insulating sheet 21 has flexibility and is configured to be extensible in the planar direction. The insulating sheet 21 is formed to contain, for example, a thermoplastic material, particularly a thermoplastic elastomer, as a main component. The insulating sheet 21 may be made of a thermoplastic elastomer itself, or may be made mainly of an elastomer that is crosslinked by heating a thermoplastic elastomer as a material.

Further, the insulating sheet 21 may contain rubber, resin, or other materials other than a thermoplastic elastomer. For example, in the case where the insulating sheet 21 contains rubber such as ethylene-propylene rubber (EPM, EPDM), the flexibility of the insulating sheet 21 is improved. From the viewpoint of improving the flexibility of the insulating sheet 21, the insulating sheet 21 may contain a flexibility-imparting component such as a plasticizer. Furthermore, the insulating sheet 21 may be made mainly of a reactive curing elastomer or a thermosetting elastomer.

Furthermore, the insulating sheet 21 is preferably a material with good thermal conductivity. Therefore, the insulating sheet 21 may use a thermoplastic elastomer having high thermal conductivity, or may contain a filler that can increase thermal conductivity.

A plurality of first electrode layers 22 are arranged in the planar direction of the insulating sheet 21 on the first surface 24 side of the insulating sheet 21, and the second electrode layers 23 are arranged in the planar direction of the insulating sheet 21 on the second surface 25 side of the insulating sheet 21. The first electrode layer 22 and the second electrode layer 23 have electrical conductivity. Furthermore, the first electrode layer 22 and the second electrode layer 23 are flexible. In other words, the first electrode layer 22 and the second electrode layer 23 have flexibility and are configured to be extensible in the planar direction.

The first electrode layer 22 and the second electrode layer 23 may be made of an electrically conductive elastomer. In the case where the first electrode layer 22 and the second electrode layer 23 are made of an electrically conductive elastomer, the first electrode layer 22 and the second electrode layer 23 are formed by using an elastomer as a base material and by containing an electrically conductive filler. The elastomer that is the base material of the first electrode layer 22 and the second electrode layer 23 may have the same main component as the insulating sheet 21, or may use a different material. The first electrode layer 22 and the second electrode layer 23 are bonded to the insulating sheet 21 by fusion (thermal fusion) with each other.

The first electrode layer 22 and the second electrode layer 23 may be made of an electrically conductive cloth. The electrically conductive cloth is a woven or nonwoven fabric made of electrically conductive fibers. Here, the electrically conductive fibers are formed by coating the surface of flexible fibers with an electrically conductive material. The electrically conductive fibers are formed, for example, by plating the surface of resin fibers such as polyethylene with copper or nickel. In this case, the first electrode layer 22 and the second electrode layer 23 are bonded to the insulating sheet 21 by fusion (thermal fusion) of the insulating sheet 21 itself.

The first electrode layer 22 and the second electrode layer 23 may be made of a metal foil. The metal foil may be any conductive metal material such as a copper foil or an aluminum foil. Furthermore, the first electrode layer 22 and the second electrode layer 23 are bonded to a sensor sheet by fusion (thermal fusion) of the insulating sheet 21 itself, in the same manner as in the case of an electrically conductive cloth.

### 3. Overall configuration of the contact detection apparatus 10

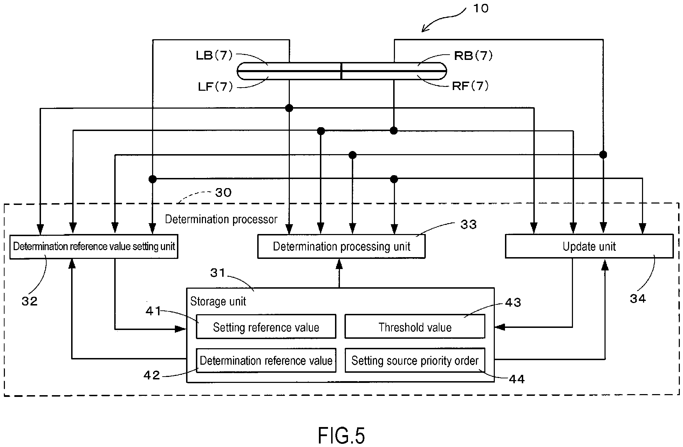

As shown in FIG. 5, the contact detection apparatus 10 includes the electrostatic sensor 7 and a determination processor 30. The determination processor 30 includes a storage unit 31, a determination reference value setting unit 32, a determination processing unit 33, and an update unit 34.

The storage unit 31 stores a setting reference value 41 which is the capacitance equivalent value corresponding to a state where no conductor is in contact with each of the detection regions LF, RF, LB, and RB, a determination reference value 42 for each of the detection regions LF, RF, LB, and RB, and a threshold value 43 associated with each of the detection regions LF, RF, LB, and RB. The threshold value 43 may be commonly associated with each of the detection regions LF, RF, LB, and RB, or may be individually associated with each of the detection regions LF, RF, LB, and RB.

The storage unit 31 further stores a setting source priority order 44. The setting target for the determination reference value 42 among the detection regions LF, RF, LB, and RB is set as a target detection region 51, and a detection region different from the target detection region 51 among the detection regions LF, RF, LB, and RB is set as a setting source detection region 52 which is the setting source for the determination reference value 42. The setting source priority order 44 is defined as the priority order of the setting source detection region 52. That is, in the case where a plurality of setting source detection regions 52 exist, the setting source priority order 44 is the order as to which of the plurality of setting source detection regions 52 is set as the source for setting the determination reference value 42 of the target detection region 51. Table 1 shows the setting source priority order 44 corresponding to each of the detection regions LF, RF, LB, and RB. In this embodiment, the setting source priority order 44 is set to a different order for each of the detection regions LF, RF, LB, and RB.

### [Table 1]

**(Table 1)**

| | | 1 | 2 | 3 | 4 |
|---|---|---|---|---|---|
| Target detection region | | LF | LB | RF | RB |
| Setting source priority order | 1 | RF | RB | LF | LB |
| | 2 | RB | RF | LB | LF |
| | 3 | LB | LF | RB | RF |
| | 4 | Setting reference value | Setting reference value | Setting reference value | Setting reference value |

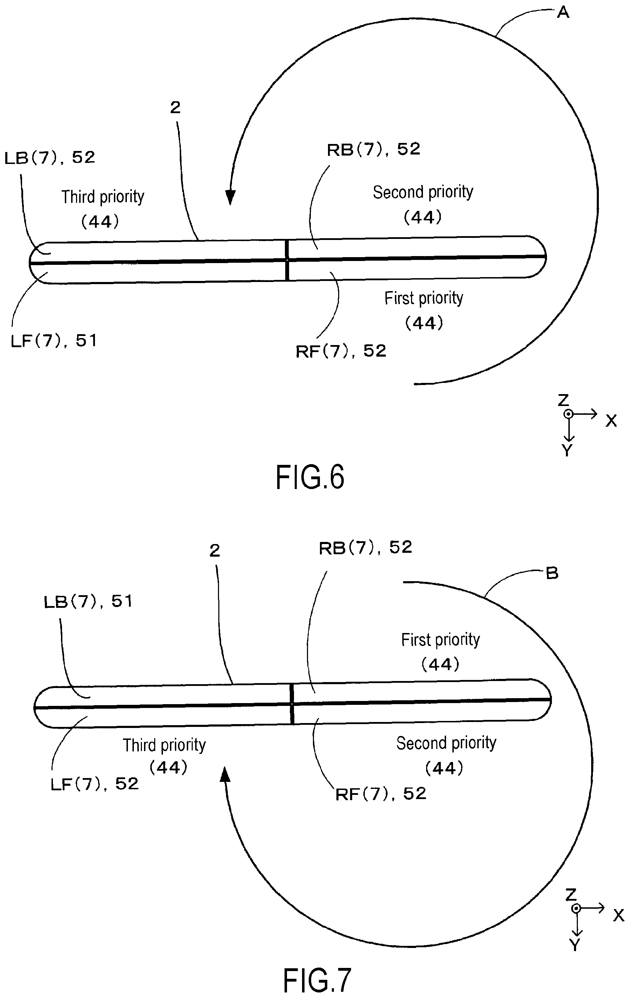

As shown in the first column of Table 1 and FIG. 6, when the left front detection region LF is set as the target detection region 51, the left back detection region LB, the right front detection region RF, and the right back detection region RB are set as the setting source detection regions 52. In this embodiment, the setting source priority order 44 is set so that the right front detection region RF is the first, the right back detection region RB is the second, and the left back detection region LB is the third. The lowest (fourth in this embodiment) in the setting source priority order 44 is set as the setting reference value 41 corresponding to the left front detection region LF. In this embodiment, the right front detection region RF, which is located on the same side as the left front detection region LF, which is the target detection region 51, in the front-back direction but on the opposite side in the left-right direction, is set as the first priority in the setting source priority order 44. In addition, the right back detection region RB, which is located on the opposite side to the left front detection region LF, which is the target detection region 51, in the left-right direction and the front-back direction, is set as the second priority in the setting source priority order 44.

As shown in the second column of Table 1 and FIG. 7, when the left back detection region LB is set as the target detection region 51, the right back detection region RB, the right front detection region RF, and the right front detection region RF are set as the setting source detection regions 52. In this embodiment, the setting source priority order 44 is set so that the right back detection region RB is the first, the right front detection region RF is the second, and the left front detection region LF is the third. The lowest (fourth in this embodiment) in the setting source priority order 44 is set as the setting reference value 41 corresponding to the left back detection region LB. In this embodiment, the right back detection region RB, which is located on the same side as the left back detection region LB, which is the target detection region 51, in the front-back direction but on the opposite side in the left-right direction, is set as the first priority in the setting source priority order 44. In addition, the right front detection region RF, which is located on the opposite side to the left back detection region LB, which is the target detection region 51, in the left-right direction and the front-back direction, is set as the second priority in the setting source priority order 44.

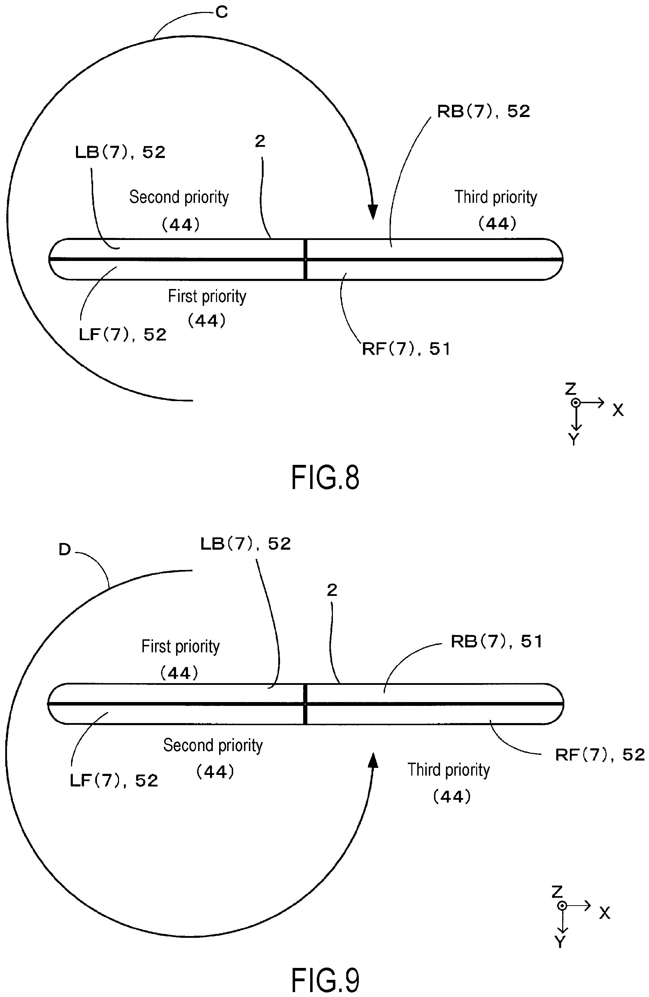

As shown in the third column of Table 1 and FIG. 8, when the right front detection region RF is set as the target detection region 51, the left front detection region LF, the left back detection region LB, and the right back detection region RB are set as the setting source detection regions 52. In this embodiment, the setting source priority order 44 is set so that the left front detection region LF is the first, the left back detection region LB is the second, and the right back detection region RB is the third. The lowest (fourth in this embodiment) in the setting source priority order 44 is set as the setting reference value 41 corresponding to the right front detection region RF. In this embodiment, the left front detection region LF, which is located on the same side as the right front detection region RF, which is the target detection region 51, in the front-back direction but on the opposite side in the left-right direction, is set as the first priority in the setting source priority order 44. In addition, the left back detection region LB, which is located on the opposite side to the right front detection region RF, which is the target detection region 51, in the left-right direction and the front-back direction, is set as the second priority in the setting source priority order 44.

As shown in the fourth column of Table 1 and FIG. 9, when the right back detection region RB is set as the target detection region 51, the left back detection region LB, the left front detection region LF, and the right front detection region RF are set as the setting source detection regions 52. In this embodiment, the setting source priority order 44 is set so that the left back detection region LB is the first, the left front detection region LF is the second, and the right back detection region RB is the third. The lowest (fourth in this embodiment) in the setting source priority order 44 is set as the setting reference value 41 corresponding to the right back detection region RB. In this embodiment, the left back detection region LB, which is located on the same side as the right back detection region RB, which is the target detection region 51, in the front-back direction but on the opposite side in the left-right direction, is set as the first priority in the setting source priority order 44. In addition, the left front detection region LF, which is located on the opposite side to the right back detection region RB, which is the target detection region 51, in the left-right direction and the front-back direction, is set as the second priority in the setting source priority order 44.

However, as the setting reference value 41, an individual value may be set for each of the detection regions LF, RF, LB, and RB, or a common value may be set for all of the detection regions LF, RF, LB, and RB.

Returning to FIG. 5, the determination reference value setting unit 32 is configured to set the determination reference value 42 for each of the detection regions LF, RF, LB, and RB by an initial process performed after the contact detection apparatus 10 is started.

The determination processing unit 33 is configured to detect whether a conductor is in contact with the detection regions LF, RF, LB, and RB by comparing the capacitance equivalent value with the determination reference value 42 in each of the detection regions LF, RF, LB, and RB after the initial process is performed. However, the contact of a conductor with the detection regions LF, RF, LB, and RB includes not only a case where the conductor is in contact with the detection regions LF, RF, LB, and RB directly, but also a case where the conductor is in contact with the detection regions LF, RF, LB, and RB indirectly via the skin material 8.

The update unit 34 updates the setting reference value 41 to the capacitance equivalent value or a value based on the capacitance equivalent value when determining a non-contact region where no conductor is in contact with the detection regions LF, RF, LB, and RB by comparing the capacitance equivalent value with the setting reference value 41 in each of the detection regions LF, RF, LB, and RB.

### 4. Operation of the contact detection apparatus 10

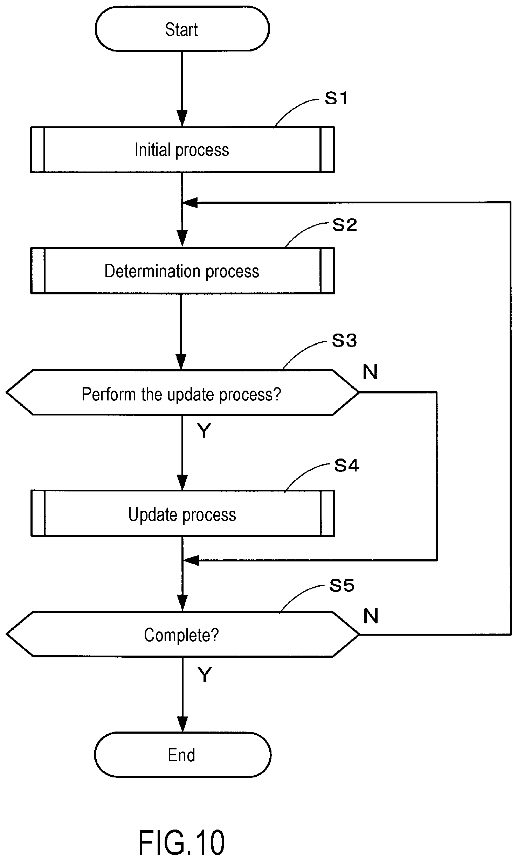

(1) Next, the operation of the contact detection apparatus 10 will be described. FIG. 10 shows a flowchart according to the main routine of the operation of the contact detection apparatus 10.

As shown in FIG. 10, when the contact detection apparatus 10 is started, the initial process is performed (S1). Next, a determination process is performed (S2). Next, whether to perform an update process is determined (S3). Whether to perform the update process may be determined based on, for example, whether a predetermined time has elapsed since the contact detection apparatus 10 is started. When determining that the update process is to be performed (S3: Y), the update process is performed (S4).

When the update process is performed, whether to end the operation of the contact detection apparatus 10 is determined (S5). Also, whether to end the operation of the contact detection apparatus 10 is determined (S5) when determining that the update process is not to be performed (S3: N). When determining that the operation of the contact detection apparatus 10 is not to be ended (S5: N), the flow returns to S2, and the operations of S2 to S4 are repeated until determining that the operation of the contact detection apparatus 10 is to be ended. When determining that the operation of the contact detection apparatus 10 is to be ended (S5: Y), the operation of the contact detection apparatus 10 is ended.

### (2) Initial process

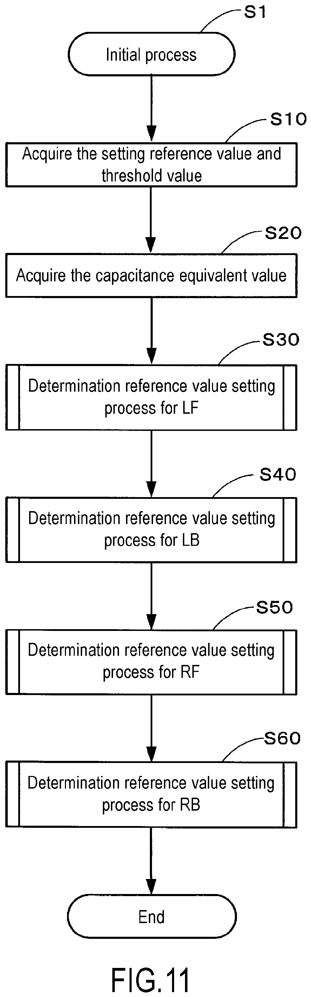

Next, the initial process will be described with reference to FIG. 11. FIG. 11 shows a flowchart of the initial process. When the initial process is performed (S1), the determination reference value setting unit 32 acquires the setting reference value 41, the threshold value 43, and the setting source priority order 44 corresponding to each of the detection regions LF, RF, LB, and RB from the storage unit 31 (S10). Next, the determination reference value setting unit 32 acquires the capacitance equivalent values of the left front detection region LF, the left back detection region LB, the right front detection region RF, and the right back detection region RB (S20).

Next, the determination reference value setting unit 32 performs a determination reference value setting process for the left front detection region LF (S30). Thereby, the determination reference value setting unit 32 sets the determination reference value 42 for the left front detection region LF, and stores the set determination reference value 42 for the left front detection region LF in the storage unit 31.

Next, the determination reference value setting unit 32 performs the determination reference value setting process for the left back detection region LB (S40). Thereby, the determination reference value setting unit 32 sets the determination reference value 42 for the left back detection region LB, and stores the set determination reference value 42 for the left back detection region LB in the storage unit 31.

Next, the determination reference value setting unit 32 performs the determination reference value setting process for the right front detection region RF (S50). Thereby, the determination reference value setting unit 32 sets the determination reference value 42 for the right front detection region RF, and stores the set determination reference value 42 for the right front detection region RF in the storage unit 31.

Next, the determination reference value setting unit 32 performs the determination reference value setting process for the right back detection region RB (S60). Thereby, the determination reference value setting unit 32 sets the determination reference value 42 for the right back detection region RB, and stores the set determination reference value 42 for the right back detection region RB in the storage unit 31.

Thereby, the initial process is completed. However, there is no particular limitation on the order in which the initial process is performed on the detection regions LF, RF, LB, and RB, and the initial process may be performed in any order.

### (A) Determination reference value setting process for the left front detection region LF

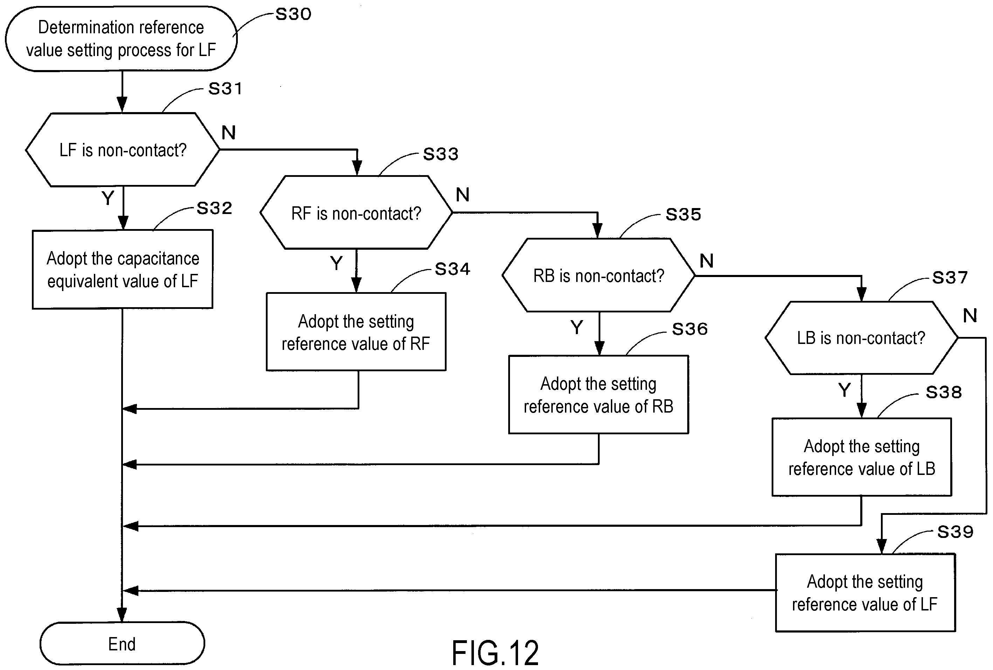

Next, FIG. 12 shows a flowchart of the determination reference value setting process for the left front detection region LF. When the determination reference value setting process for the left front detection region LF is performed (S30), the determination reference value setting unit 32 sets the left front detection region LF as the target detection region 51, and sets the left back detection region LB, the right front detection region RF, and the right back detection region RB as the setting source detection regions 52.

The determination reference value setting unit 32 determines whether the left front detection region LF, which is the target detection region 51, is a non-contact region (S31). The determination reference value setting unit 32 calculates the difference between the capacitance equivalent value of the left front detection region LF and the setting reference value 41 corresponding to the left front detection region LF. When this difference is equal to or less than the threshold value 43 corresponding to the left front detection region LF, the determination reference value setting unit 32 determines that the left front detection region LF is a non-contact region where no conductor is in contact (S31: Y).

For the left front detection region LF determined to be a non-contact region, the determination reference value setting unit 32 adopts and sets the capacitance equivalent value of the left front detection region LF as the setting reference value 41 of the left front detection region LF. Thereby, the determination reference value setting process for the left front detection region LF is completed. However, in the case of adopting the capacitance equivalent value as the setting reference value 41, a value obtained by performing a predetermined process (for example, filter process) on the capacitance equivalent value (an example of the value based on the capacitance equivalent value) may be adopted as the setting reference value 41, instead of the capacitance equivalent value. The same applies below.

In S31, when the difference from the setting reference value 41 corresponding to the left front detection region LF exceeds the threshold value 43 corresponding to the left front detection region LF, the determination reference value setting unit 32 determines that the left front detection region LF is not a non-contact region (S31: N). That is, the determination reference value setting unit 32 determines the left front detection region LF as a contact region where a conductor is in contact.

Next, the determination reference value setting unit 32 determines whether the setting source detection region 52 is a non-contact region in the order defined in the setting source priority order 44.

FIG. 6 shows the setting source priority order 44 when the left front detection region LF is set as the target detection region 51. The setting source priority order 44 of this embodiment is set so that the position adjacent to the right of the left front detection region LF is given the first priority. Thereby, in this embodiment, the right front detection region RF is set as the first priority (see the first column of Table 1).

The setting source priority order 44 of this embodiment is set so that the diagonal position of the left front detection region LF is given the second priority. Thereby, in this embodiment, the right back detection region RB is set as the second priority (see the first column of Table 1).

In this embodiment, the left back detection region LB located on the back surface side of the left front detection region LF is set as the third priority (see the first column of Table 1). In this embodiment, the detection source priority order is set so that the priority lowers along the direction indicated by arrow A in FIG. 6.

Returning to FIG. 12, the determination reference value setting unit 32 determines whether the right front detection region RF is non-contact based on the setting source priority order 44 (S33). The determination reference value setting unit 32 calculates the difference between the capacitance equivalent value of the right front detection region RF and the setting reference value 41 corresponding to the right front detection region RF. When this difference is equal to or less than the threshold value 43 corresponding to the right front detection region RF, the determination reference value setting unit 32 determines that the right front detection region RF is a non-contact region where no conductor is in contact (S33: Y).

As the determination reference value 42 of the left front detection region LF determined to be a contact region in S31, the determination reference value setting unit 32 adopts and sets the setting reference value 41 corresponding to the right front detection region RF determined to be a non-contact region in S33 as the setting reference value 41 of the left front detection region LF. Thereby, the determination reference value setting process for the left front detection region LF is completed.

In S33, when the difference from the setting reference value 41 corresponding to the right front detection region RF exceeds the threshold value 43 corresponding to the right front detection region RF, the determination reference value setting unit 32 determines that the right front detection region RF is not a non-contact region (S33: N). That is, the determination reference value setting unit 32 determines the right front detection region RF as a contact region where a conductor is in contact.

Next, the determination reference value setting unit 32 determines whether the right back detection region RB, which is the second in the setting source priority order 44, is a non-contact region (S35). The determination reference value setting unit 32 calculates the difference between the capacitance equivalent value of the right back detection region RB and the setting reference value 41 corresponding to the right back detection region RB. When this difference is equal to or less than the threshold value 43 corresponding to the right back detection region RB, the determination reference value setting unit 32 determines that the right back detection region RB is a non-contact region where no conductor is in contact (S35: Y).

As the determination reference value 42 of the left front detection region LF determined to be a contact region in S31, the determination reference value setting unit 32 adopts and sets the setting reference value 41 corresponding to the right back detection region RB determined to be a non-contact region in S35 as the setting reference value 41 of the left front detection region LF. Thereby, the determination reference value setting process for the left front detection region LF is completed.

In S35, when the difference from the setting reference value 41 corresponding to the right back detection region RB exceeds the threshold value 43 corresponding to the right back detection region RB, the determination reference value setting unit 32 determines that the right back detection region RB is not a non-contact region (S35: N). That is, the determination reference value setting unit 32 determines the right back detection region RB as a contact region where a conductor is in contact.

Next, the determination reference value setting unit 32 determines whether the left back detection region LB, which is the third in the setting source priority order 44, is a non-contact region (S37). The determination reference value setting unit 32 calculates the difference between the capacitance equivalent value of the left back detection region LB and the setting reference value 41 corresponding to the left back detection region LB. When this difference is equal to or less than the threshold value 43 corresponding to the left back detection region LB, the determination reference value setting unit 32 determines that the left back detection region LB is a non-contact region where no conductor is in contact (S37: Y).

As the determination reference value 42 of the left front detection region LF determined to be a contact region in S31, the determination reference value setting unit 32 adopts and sets the setting reference value 41 corresponding to the left back detection region LB determined to be a non-contact region in S37 as the setting reference value 41 of the left front detection region LF. Thereby, the determination reference value setting process for the left front detection region LF is completed.

In S37, when the difference from the setting reference value 41 corresponding to the left back detection region LB exceeds the threshold value 43 corresponding to the right back detection region RB, the determination reference value setting unit 32 determines that the left back detection region LB is not a non-contact region (S37: N). That is, the determination reference value setting unit 32 determines the left back detection region LB as a contact region where a conductor is in contact. The determination reference value setting unit 32 determines that all of the detection regions LF, RF, LB, and RB are contact regions.

Next, the determination reference value setting unit 32 adopts and sets the setting reference value 41 corresponding to the left front detection region LF as the determination reference value 42 of the left front detection region LF determined to be a contact region in S31 (S39). Thereby, the determination reference value setting process for the left front detection region LF is completed.

### (B) Determination reference value setting process for LB

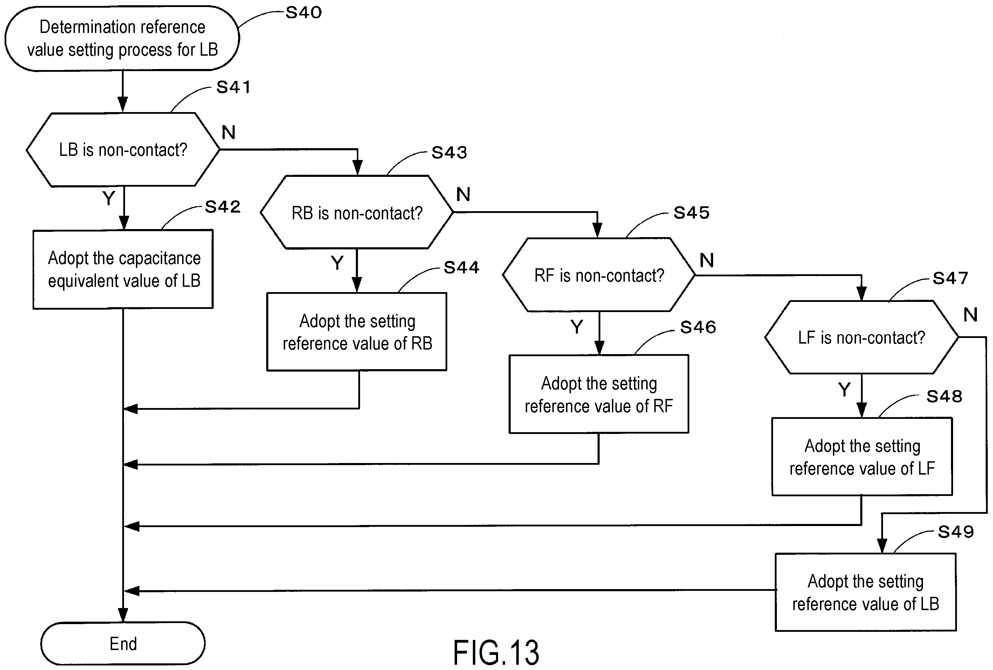

Next, FIG. 13 shows a flowchart of the determination reference value setting process for the left back detection region LB. When the determination reference value setting process for the left back detection region LB is performed (S40), the determination reference value setting unit 32 sets the left back detection region LB as the target detection region 51, and sets the right back detection region RB, the right front detection region RF, and the left back detection region LB as the setting source detection regions 52.

The determination reference value setting unit 32 determines whether the left back detection region LB, which is the target detection region 51, is a non-contact region (S41). The determination reference value setting unit 32 calculates the difference between the capacitance equivalent value of the left back detection region LB and the setting reference value 41 corresponding to the left back detection region LB. When this difference is equal to or less than the threshold value 43 corresponding to the left back detection region LB, the determination reference value setting unit 32 determines that the left back detection region LB is a non-contact region where no conductor is in contact (S41: Y).

For the left back detection region LB determined to be a non-contact region, the determination reference value setting unit 32 adopts and sets the capacitance equivalent value of the left back detection region LB as the setting reference value 41 of the left back detection region LB. Thereby, the determination reference value setting process for the left back detection region LB is completed.

In S41, when the difference from the setting reference value 41 corresponding to the left back detection region LB exceeds the threshold value 43 corresponding to the left back detection region LB, the determination reference value setting unit 32 determines that the left back detection region LB is not a non-contact region (S41: N). That is, the determination reference value setting unit 32 determines the left back detection region LB as a contact region where a conductor is in contact.

Next, the determination reference value setting unit 32 determines whether the setting source detection region 52 is a non-contact region in the order defined in the setting source priority order 44.

FIG. 7 shows the setting source priority order 44 when the left back detection region LB is set as the target detection region 51. The setting source priority order 44 of this embodiment is set so that the position adjacent to the right of the left back detection region LB is given the first priority. Thereby, in this embodiment, the right back detection region RB is set as the first priority (see the second column of Table 1).

The setting source priority order 44 of this embodiment is set so that the diagonal position of the left back detection region LB is given the second priority. Thereby, in this embodiment, the right front detection region RF is set as the second priority (see the second column of Table 1).

In this embodiment, the left front detection region LF located on the back surface side of the left back detection region LB is set as the third priority (see the second column of Table 1). In this embodiment, the detection source priority order is set so that the priority lowers along the direction indicated by arrow B in FIG. 7.

Returning to FIG. 13, the determination reference value setting unit 32 determines whether the right back detection region RB is non-contact based on the setting source priority order 44 (S43). The determination reference value setting unit 32 calculates the difference between the capacitance equivalent value of the right back detection region RB and the setting reference value 41 corresponding to the right back detection region RB. When this difference is equal to or less than the threshold value 43 corresponding to the right back detection region RB, the determination reference value setting unit 32 determines that the right back detection region RB is a non-contact region where no conductor is in contact (S43: Y).

As the determination reference value 42 of the left back detection region LB determined to be a contact region in S41, the determination reference value setting unit 32 adopts and sets the setting reference value 41 corresponding to the right back detection region RB determined to be a non-contact region in S43 as the setting reference value 41 of the left back detection region LB. Thereby, the determination reference value setting process for the left back detection region LB is completed.

In S43, when the difference from the setting reference value 41 corresponding to the right back detection region RB exceeds the threshold value 43 corresponding to the right back detection region RB, the determination reference value setting unit 32 determines that the right back detection region RB is not a non-contact region (S43: N). That is, the determination reference value setting unit 32 determines the right back detection region RB as a contact region where a conductor is in contact.

Next, the determination reference value setting unit 32 determines whether the right front detection region RF, which is the second in the setting source priority order 44, is a non-contact region (S45). The determination reference value setting unit 32 calculates the difference between the capacitance equivalent value of the right front detection region RF and the setting reference value 41 corresponding to the right front detection region RF. When this difference is equal to or less than the threshold value 43 corresponding to the right front detection region RF, the determination reference value setting unit 32 determines that the right front detection region RF is a non-contact region where no conductor is in contact (S45: Y).

As the determination reference value 42 of the left back detection region LB determined to be a contact region in S41, the determination reference value setting unit 32 adopts and sets the setting reference value 41 corresponding to the right front detection region RF determined to be a non-contact region in S45 as the setting reference value 41 of the left back detection region LB. Thereby, the determination reference value setting process for the left back detection region LB is completed.

In S45, when the difference from the setting reference value 41 corresponding to the right front detection region RF exceeds the threshold value 43 corresponding to the right front detection region RF, the determination reference value setting unit 32 determines that the right front detection region RF is not a non-contact region (S45: N). That is, the determination reference value setting unit 32 determines the right front detection region RF as a contact region where a conductor is in contact.

Next, the determination reference value setting unit 32 determines whether the left front detection region LF, which is the third in the setting source priority order 44, is a non-contact region (S47). The determination reference value setting unit 32 calculates the difference between the capacitance equivalent value of the left front detection region LF and the setting reference value 41 corresponding to the left front detection region LF. When this difference is equal to or less than the threshold value 43 corresponding to the left front detection region LF, the determination reference value setting unit 32 determines that the left front detection region LF is a non-contact region where no conductor is in contact (S47: Y).

As the determination reference value 42 of the left back detection region LB determined to be a contact region in S41, the determination reference value setting unit 32 adopts and sets the setting reference value 41 corresponding to the left front detection region LF determined to be a non-contact region in S47 as the setting reference value 41 of the left back detection region LB. Thereby, the determination reference value setting process for the left back detection region LB is completed.

In S47, when the difference from the setting reference value 41 corresponding to the left front detection region LF exceeds the threshold value 43 corresponding to the right front detection region RF, the determination reference value setting unit 32 determines that the left front detection region LF is not a non-contact region (S47: N). That is, the determination reference value setting unit 32 determines the left front detection region LF as a contact region where a conductor is in contact. The determination reference value setting unit 32 determines that all of the detection regions are contact regions.

Next, the determination reference value setting unit 32 adopts and sets the setting reference value 41 corresponding to the left back detection region LB as the determination reference value 42 of the left back detection region LB determined to be a contact region in S41 (S49). Thereby, the determination reference value setting process for the left back detection region LB is completed.

### (C) Determination reference value setting process for RF

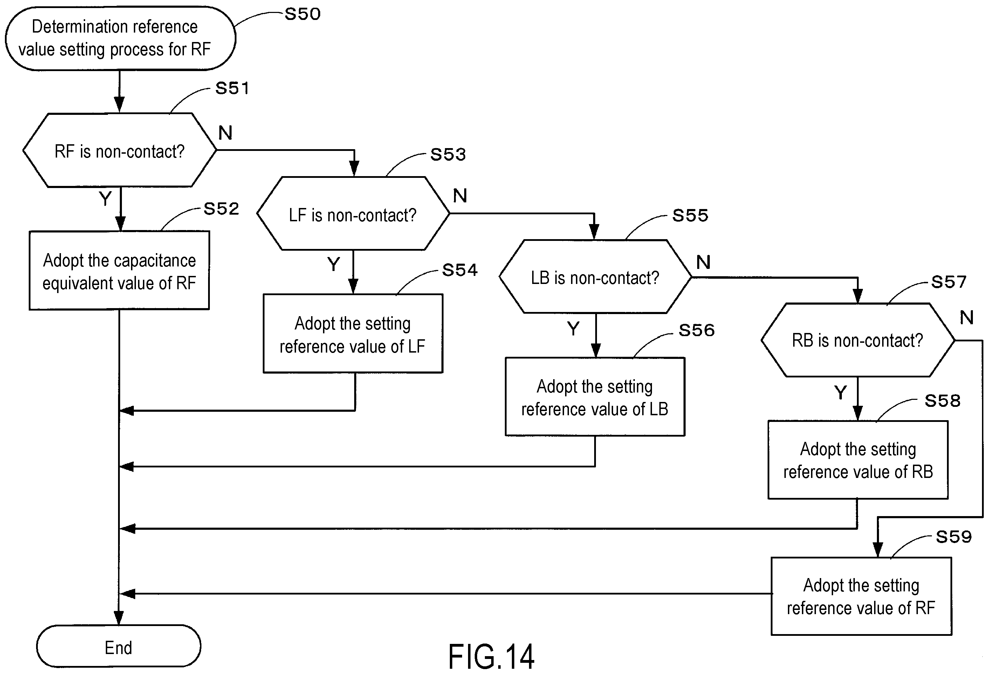

Next, FIG. 14 shows a flowchart of the determination reference value setting process for the right front detection region RF. When the determination reference value setting process for the right front detection region RF is performed (S50), the determination reference value setting unit 32 sets the right front detection region RF as the target detection region 51, and sets the left front detection region LF, the left back detection region LB, and the right back detection region RB as the setting source detection regions 52.

The determination reference value setting unit 32 determines whether the right front detection region RF, which is the target detection region 51, is a non-contact region (S51). The determination reference value setting unit 32 calculates the difference between the capacitance equivalent value of the right front detection region RF and the setting reference value 41 corresponding to the right front detection region RF. When this difference is equal to or less than the threshold value 43 corresponding to the right front detection region RF, the determination reference value setting unit 32 determines that the right front detection region RF is a non-contact region where no conductor is in contact (S51: Y).

For the right front detection region RF determined to be a non-contact region, the determination reference value setting unit 32 adopts and sets the capacitance equivalent value of the right front detection region RF as the setting reference value 41 of the right front detection region RF. Thereby, the determination reference value setting process for the right front detection region RF is completed.

In S51, when the difference from the setting reference value 41 corresponding to the right front detection region RF exceeds the threshold value 43 corresponding to the right front detection region RF, the determination reference value setting unit 32 determines that the right front detection region RF is not a non-contact region (S51: N). That is, the determination reference value setting unit 32 determines the right front detection region RF as a contact region where a conductor is in contact.

Next, the determination reference value setting unit 32 determines whether the setting source detection region 52 is a non-contact region in the order defined in the setting source priority order 44.

FIG. 8 shows the setting source priority order 44 when the right front detection region RF is set as the target detection region 51. The setting source priority order 44 of this embodiment is set so that the position adjacent to the left of the right front detection region RF is given the first priority. Thereby, in this embodiment, the left front detection region LF is set as the first priority (see the third column of Table 1).

The setting source priority order 44 of this embodiment is set so that the diagonal position of the right front detection region RF is given the second priority. Thereby, in this embodiment, the left back detection region LB is set as the second priority (see the third column of Table 1).

In this embodiment, the right back detection region RB located on the back surface side of the right front detection region RF is set as the third priority (see the third column of Table 1). In this embodiment, the detection source priority order is set so that the priority lowers along the direction indicated by arrow C in FIG. 8.

Returning to FIG. 14, the determination reference value setting unit 32 determines whether the left front detection region LF is non-contact based on the setting source priority order 44 (S53). The determination reference value setting unit 32 calculates the difference between the capacitance equivalent value of the left front detection region LF and the setting reference value 41 corresponding to the left front detection region LF. When this difference is equal to or less than the threshold value 43 corresponding to the left front detection region LF, the determination reference value setting unit 32 determines that the left front detection region LF is a non-contact region where no conductor is in contact (S53: Y).

As the determination reference value 42 of the right front detection region RF determined to be a contact region in S51, the determination reference value setting unit 32 adopts and sets the setting reference value 41 corresponding to the left front detection region LF determined to be a non-contact region in S53 as the setting reference value 41 of the right front detection region RF. Thereby, the determination reference value setting process for the right front detection region RF is completed.

In S53, when the difference from the setting reference value 41 corresponding to the left front detection region LF exceeds the threshold value 43 corresponding to the left front detection region LF, the determination reference value setting unit 32 determines that the left front detection region LF is not a non-contact region (S53: N). That is, the determination reference value setting unit 32 determines the left front detection region LF as a contact region where a conductor is in contact.

Next, the determination reference value setting unit 32 determines whether the left back detection region LB, which is the second in the setting source priority order 44, is a non-contact region (S55). The determination reference value setting unit 32 calculates the difference between the capacitance equivalent value of the left back detection region LB and the setting reference value 41 corresponding to the left back detection region LB. When this difference is equal to or less than the threshold value 43 corresponding to the left back detection region LB, the determination reference value setting unit 32 determines that the left back detection region LB is a non-contact region where no conductor is in contact (S55: Y).

As the determination reference value 42 of the right front detection region RF determined to be a contact region in S51, the determination reference value setting unit 32 adopts and sets the setting reference value 41 corresponding to the left back detection region LB determined to be a non-contact region in S55 as the setting reference value 41 of the right front detection region RF. Thereby, the determination reference value setting process for the right front detection region RF is completed.

In S55, when the difference from the setting reference value 41 corresponding to the left back detection region LB exceeds the threshold value 43 corresponding to the left back detection region LB, the determination reference value setting unit 32 determines that the left back detection region LB is not a non-contact region (S55: N). That is, the determination reference value setting unit 32 determines the left back detection region LB as a contact region where a conductor is in contact.

Next, the determination reference value setting unit 32 determines whether the right back detection region RB, which is the third in the setting source priority order 44, is a non-contact region (S57). The determination reference value setting unit 32 calculates the difference between the capacitance equivalent value of the right back detection region RB and the setting reference value 41 corresponding to the right back detection region RB. When this difference is equal to or less than the threshold value 43 corresponding to the right back detection region RB, the determination reference value setting unit 32 determines that the right back detection region RB is a non-contact region where no conductor is in contact (S57: Y).

As the determination reference value 42 of the right front detection region RF determined to be a contact region in S51, the determination reference value setting unit 32 adopts and sets the setting reference value 41 corresponding to the right back detection region RB determined to be a non-contact region in S57 as the setting reference value 41 of the right front detection region RF. Thereby, the determination reference value setting process for the right front detection region RF is completed.

In S57, when the difference from the setting reference value 41 corresponding to the right back detection region RB exceeds the threshold value 43 corresponding to the right back detection region RB, the determination reference value setting unit 32 determines that the right back detection region RB is not a non-contact region (S57: N). That is, the determination reference value setting unit 32 determines the right back detection region RB as a contact region where a conductor is in contact. The determination reference value setting unit 32 determines that all of the detection regions LF, RF, LB, and RB are contact regions.

Next, the determination reference value setting unit 32 adopts and sets the setting reference value 41 corresponding to the right front detection region RF as the determination reference value 42 of the right front detection region RF determined to be a contact region in S51 (S59). Thereby, the determination reference value setting process for the right front detection region RF is completed.

### (D) Determination reference value setting process for RB

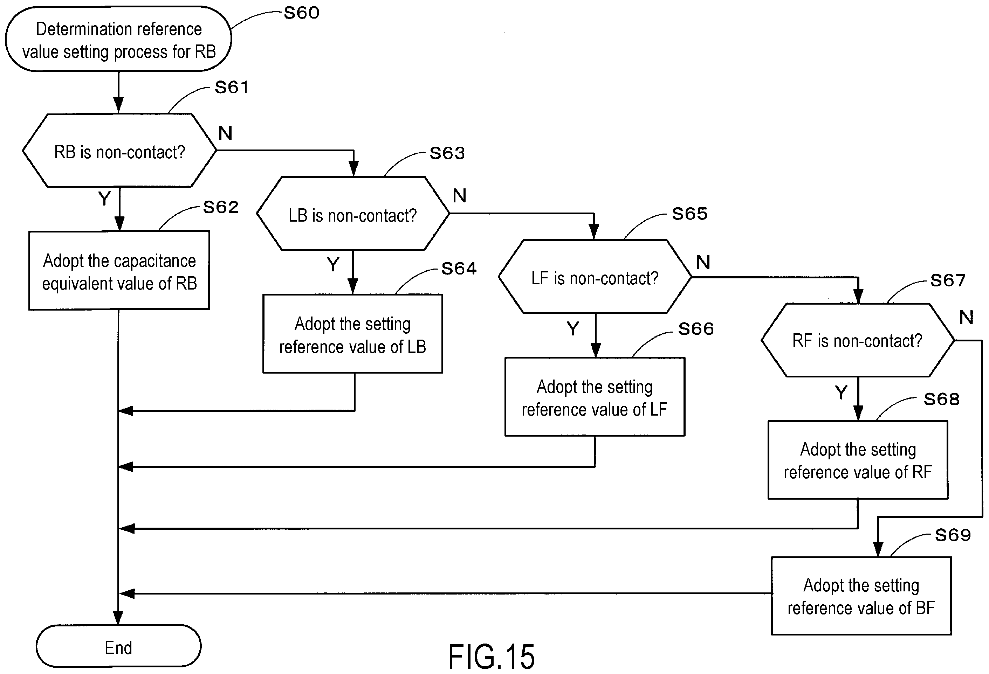

Next, FIG. 15 shows a flowchart of the determination reference value setting process for the right back detection region RB. When the determination reference value setting process for the right back detection region RB is performed (S60), the determination reference value setting unit 32 sets the right back detection region RB as the target detection region 51, and sets the left back detection region LB, the left front detection region LF, and the right front detection region RF as the setting source detection regions 52.

The determination reference value setting unit 32 determines whether the right back detection region RB, which is the target detection region 51, is a non-contact region (S61). The determination reference value setting unit 32 calculates the difference between the capacitance equivalent value of the right back detection region RB and the setting reference value 41 corresponding to the right back detection region RB. When this difference is equal to or less than the threshold value 43 corresponding to the right back detection region RB, the determination reference value setting unit 32 determines that the right back detection region RB is a non-contact region where no conductor is in contact (S61: Y).

For the right back detection region RB determined to be a non-contact region, the determination reference value setting unit 32 adopts and sets the capacitance equivalent value of the right back detection region RB as the setting reference value 41 of the right back detection region RB. Thereby, the determination reference value setting process for the right back detection region RB is completed.

In S61, when the difference from the setting reference value 41 corresponding to the right back detection region RB exceeds the threshold value 43 corresponding to the right back detection region RB, the determination reference value setting unit 32 determines that the right back detection region RB is not a non-contact region (S61: N). That is, the determination reference value setting unit 32 determines the right back detection region RB as a contact region where a conductor is in contact.

Next, the determination reference value setting unit 32 determines whether the setting source detection region 52 is a non-contact region in the order defined in the setting source priority order 44.

FIG. 9 shows the setting source priority order 44 when the right back detection region RB is set as the target detection region 51. The setting source priority order 44 of this embodiment is set so that the position adjacent to the left of the right back detection region RB is given the first priority. Thereby, in this embodiment, the left back detection region LB is set as the first priority (see the fourth column of Table 1).

The setting source priority order 44 of this embodiment is set so that the diagonal position of the right back detection region RB is given the second priority (see the fourth column of Table 1). Thereby, in this embodiment, the left front detection region LF is set as the second priority.

In this embodiment, the right front detection region RF located on the back surface side of the right back detection region RB is set as the third priority (see the fourth column of Table 1). In this embodiment, the detection source priority order is set so that the priority lowers along the direction indicated by arrow D in FIG. 9.

Returning to FIG. 15, the determination reference value setting unit 32 determines whether the left back detection region LB is non-contact based on the setting source priority order 44 (S63). The determination reference value setting unit 32 calculates the difference between the capacitance equivalent value of the left back detection region LB and the setting reference value 41 corresponding to the left back detection region LB. When this difference is equal to or less than the threshold value 43 corresponding to the left back detection region LB, the determination reference value setting unit 32 determines that the left back detection region LB is a non-contact region where no conductor is in contact (S63: Y).

As the determination reference value 42 of the right back detection region RB determined to be a contact region in S61, the determination reference value setting unit 32 adopts and sets the setting reference value 41 corresponding to the left back detection region LB determined to be a non-contact region in S63 as the setting reference value 41 of the right back detection region RB. Thereby, the determination reference value setting process for the right back detection region RB is completed.

In S63, when the difference from the setting reference value 41 corresponding to the left back detection region LB exceeds the threshold value 43 corresponding to the left back detection region LB, the determination reference value setting unit 32 determines that the left back detection region LB is not a non-contact region (S63: N). That is, the determination reference value setting unit 32 determines the left back detection region LB as a contact region where a conductor is in contact.

Next, the determination reference value setting unit 32 determines whether the left front detection region LF, which is the second in the setting source priority order 44, is a non-contact region (S65). The determination reference value setting unit 32 calculates the difference between the capacitance equivalent value of the left front detection region LF and the setting reference value 41 corresponding to the left front detection region LF. When this difference is equal to or less than the threshold value 43 corresponding to the left front detection region LF, the determination reference value setting unit 32 determines that the left front detection region LF is a non-contact region where no conductor is in contact (S65: Y).

As the determination reference value 42 of the right back detection region RB determined to be a contact region in S61, the determination reference value setting unit 32 adopts and sets the setting reference value 41 corresponding to the left front detection region LF determined to be a non-contact region in S65 as the setting reference value 41 of the right back detection region RB. Thereby, the determination reference value setting process for the right back detection region RB is completed.

In S65, when the difference from the setting reference value 41 corresponding to the left front detection region LF exceeds the threshold value 43 corresponding to the left front detection region LF, the determination reference value setting unit 32 determines that the left front detection region LF is not a non-contact region (S65: N). That is, the determination reference value setting unit 32 determines the left front detection region LF as a contact region where a conductor is in contact.

Next, the determination reference value setting unit 32 determines whether the right front detection region RF, which is the third in the setting source priority order 44, is a non-contact region (S67). The determination reference value setting unit 32 calculates the difference between the capacitance equivalent value of the right front detection region RF and the setting reference value 41 corresponding to the right front detection region RF. When this difference is equal to or less than the threshold value 43 corresponding to the right front detection region RF, the determination reference value setting unit 32 determines that the right front detection region RF is a non-contact region where no conductor is in contact (S67: Y).

As the determination reference value 42 of the right back detection region RB determined to be a contact region in S61, the determination reference value setting unit 32 adopts and sets the setting reference value 41 corresponding to the right front detection region RF determined to be a non-contact region in S67 as the setting reference value 41 of the right back detection region RB. Thereby, the determination reference value setting process for the right back detection region RB is completed.

In S67, when the difference from the setting reference value 41 corresponding to the right front detection region RF exceeds the threshold value 43 corresponding to the right front detection region RF, the determination reference value setting unit 32 determines that the right front detection region RF is not a non-contact region (S67: N). That is, the determination reference value setting unit 32 determines the right front detection region RF as a contact region where a conductor is in contact. The determination reference value setting unit 32 determines that all of the detection regions LF, RF, LB, and RB are contact regions.

Next, the determination reference value setting unit 32 adopts and sets the setting reference value 41 corresponding to the right back detection region RB as the determination reference value 42 of the right back detection region RB determined to be a contact region in S61 (S69). Thereby, the determination reference value setting process for the right back detection region RB is completed.

### (3) Determination process

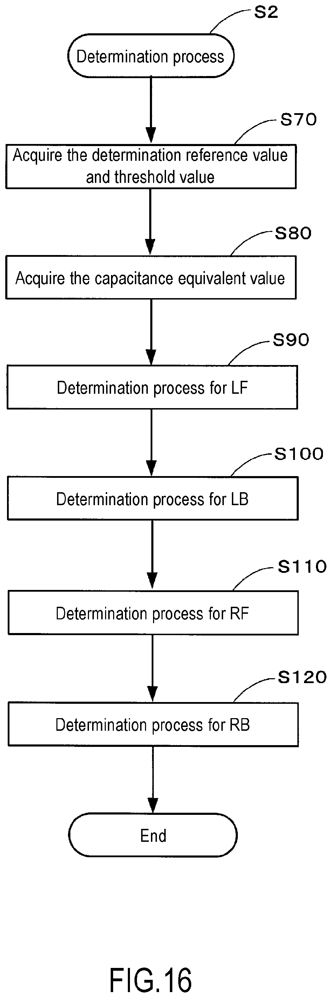

Next, the determination process will be described with reference to FIG. 16. FIG. 16 shows a flowchart of the determination process. When the determination process is performed (S2), the determination processing unit 33 acquires the determination reference value 42 and the threshold value 43 corresponding to each of the detection regions LF, RF, LB, and RB from the storage unit 31 (S70). Next, the determination reference value setting unit 32 acquires the capacitance equivalent values of the left front detection region LF, the left back detection region LB, the right front detection region RF, and the right back detection region RB (S80).

Next, the determination processing unit 33 performs the determination process for the left front detection region LF (S90). The determination processing unit 33 calculates the difference between the capacitance equivalent value of the left front detection region LF and the determination reference value 42 corresponding to the left front detection region LF. When this difference exceeds the threshold value 43 corresponding to the left front detection region LF, the determination processing unit 33 determines that a conductor is in contact with the left front detection region LF. On the other hand, when the difference from the determination reference value 42 corresponding to the left front detection region LF is equal to or less than the threshold value 43 corresponding to the left front detection region LF, the determination processing unit 33 determines that no conductor is in contact with the left front detection region LF. The determination processing unit 33 transmits information regarding whether a conductor has come into contact with the left front detection region LF to a predetermined transmission destination.

Next, the determination processing unit 33 performs the determination process for the left back detection region LB (S100). The determination processing unit 33 calculates the difference between the capacitance equivalent value of the left back detection region LB and the determination reference value 42 corresponding to the left back detection region LB. When this difference exceeds the threshold value 43 corresponding to the left back detection region LB, the determination processing unit 33 determines that a conductor is in contact with the left back detection region LB. On the other hand, when the difference from the determination reference value 42 corresponding to the left back detection region LB is equal to or less than the threshold value 43 corresponding to the left back detection region LB, the determination processing unit 33 determines that no conductor is in contact with the left back detection region LB. The determination processing unit 33 transmits information regarding whether a conductor has come into contact with the left back detection region LB to a predetermined transmission destination.

Next, the determination processing unit 33 performs the determination process for the right front detection region RF (S110). The determination processing unit 33 calculates the difference between the capacitance equivalent value of the right front detection region RF and the determination reference value 42 corresponding to the right front detection region RF. When this difference exceeds the threshold value 43 corresponding to the right front detection region RF, the determination processing unit 33 determines that a conductor is in contact with the right front detection region RF. On the other hand, when the difference from the determination reference value 42 corresponding to the right front detection region RF is equal to or less than the threshold value 43 corresponding to the right front detection region RF, the determination processing unit 33 determines that no conductor is in contact with the right front detection region RF. The determination processing unit 33 transmits information regarding whether a conductor has come into contact with the right front detection region RF to a predetermined transmission destination.

Next, the determination processing unit 33 performs the determination process for the right back detection region RB (S120). The determination processing unit 33 calculates the difference between the capacitance equivalent value of the right back detection region RB and the determination reference value 42 corresponding to the right back detection region RB. When this difference is equal to or less than the threshold value 43 corresponding to the right back detection region RB, the determination processing unit 33 determines that a conductor is in contact with the right back detection region RB. On the other hand, when the difference from the determination reference value 42 corresponding to the right back detection region RB exceeds the threshold value 43 corresponding to the right back detection region RB, the determination processing unit 33 determines that no conductor is in contact with the right back detection region RB. The determination processing unit 33 transmits information regarding whether a conductor has come into contact with the right back detection region RB to a predetermined transmission destination.

Thereby, the determination process is completed. However, there is no particular limitation on the order in which the determination process is performed on the detection regions LF, RF, LB, and RB, and the determination process may be performed in any order.

### (4) Update process

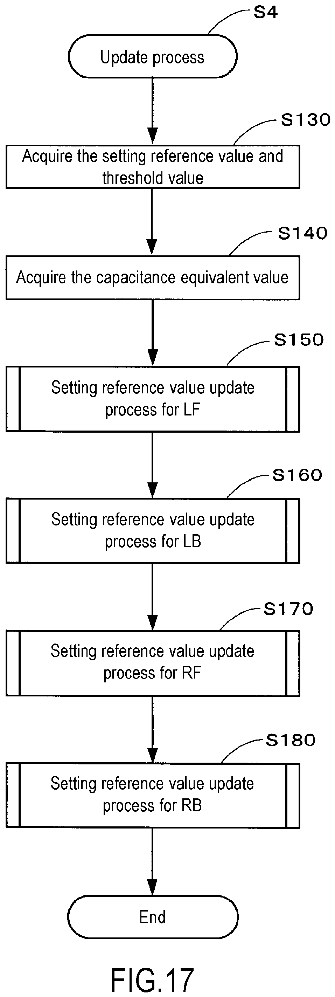

Next, the update process will be described with reference to FIG. 17. FIG. 17 shows a flowchart of the update process. When the update process is performed (S4), the update unit 34 acquires the setting reference value 41 and the threshold value 43 corresponding to each of the detection regions LF, RF, LB, and RB from the storage unit 31 (S130). Next, the update unit 34 acquires the capacitance equivalent values of the left front detection region LF, the left back detection region LB, the right front detection region RF, and the right back detection region RB (S140).

Next, the update unit 34 performs the update process for the left front detection region LF (S150). Thereby, when determining that the left front detection region LF is a non-contact region, the update unit 34 updates the capacitance equivalent value of the left front detection region LF to the setting reference value 41 of the left front detection region LF, and stores the updated determination reference value 42 of the left front detection region LF in the storage unit 31. However, instead of the capacitance equivalent value of the left front detection region LF, a value obtained by performing a predetermined process (for example, filter process) on the capacitance equivalent value (an example of the value based on the capacitance equivalent value) may be updated to the setting reference value 41 of the left front detection region LF. The same applies below.

Next, the update unit 34 performs the update process for the left back detection region LB (S160). Thereby, when determining that the left back detection region LB is a non-contact region, the update unit 34 updates the capacitance equivalent value of the left back detection region LB to the setting reference value 41 of the left back detection region LB, and stores the updated determination reference value 42 of the left back detection region LB in the storage unit 31.

Next, the update unit 34 performs the update process for the right front detection region RF (S170). Thereby, when determining that the right front detection region RF is a non-contact region, the update unit 34 updates the capacitance equivalent value of the right front detection region RF to the setting reference value 41 of the right front detection region RF, and stores the updated determination reference value 42 of the right front detection region RF in the storage unit 31.

Next, the update unit 34 performs the update process for the right back detection region RB (S180). Thereby, when determining that the right back detection region RB is a non-contact region, the update unit 34 updates the capacitance equivalent value of the right back detection region RB to the setting reference value 41 of the right back detection region RB, and stores the updated determination reference value 42 of the right back detection region RB in the storage unit 31.

Thereby, the update process is completed. However, there is no particular limitation on the order in which the update process is performed on the detection regions LF, RF, LB, and RB, and the update process may be performed in any order.

### (A) Update process for LF

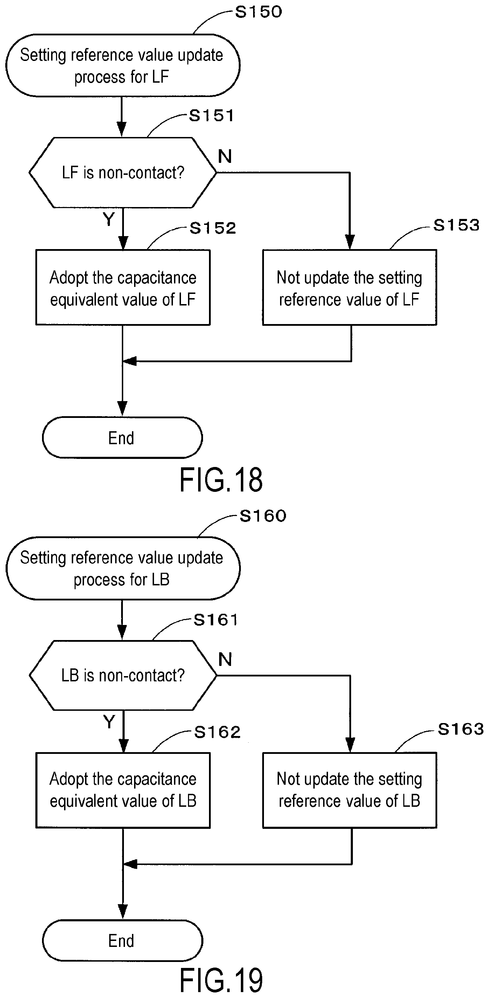

Next, FIG. 18 shows a flowchart of the update process for the left front detection region LF. When the update process for the left front detection region LF is performed (S150), the update unit 34 determines whether the left front detection region LF is a non-contact region (S151). The update unit 34 calculates the difference between the capacitance equivalent value of the left front detection region LF and the setting reference value 41 corresponding to the left front detection region LF. When this difference is equal to or less than the threshold value 43 corresponding to the left front detection region LF, the update unit 34 determines that the left front detection region LF is a non-contact region where no conductor is in contact (S151: Y).

The update adopts and updates the capacitance equivalent value of the left front detection region LF as the setting reference value 41 of the left front detection region LF for the left front detection region LF determined to be a non-contact region (S152). Thereby, the update process for the left front detection region LF is completed.

In S151, when the difference from the setting reference value 41 corresponding to the left front detection region LF exceeds the threshold value 43 corresponding to the left front detection region LF, the update unit 34 determines that the left back detection region LB is not a non-contact region (S151: N). That is, the update unit 34 determines the left back detection region LB as a contact region where a conductor is in contact. The update unit 34 does not update the setting reference value 41 corresponding to the left back detection region LB (S153). Thereby, the update process for the left back detection region LB is completed.

### (B) Update process for LB

Next, FIG. 19 shows a flowchart of the update process for the left back detection region LB. When the update process for the left back detection region LB is performed (S160), the update unit 34 determines whether the left back detection region LB is a non-contact region (S161). The update unit 34 calculates the difference between the capacitance equivalent value of the left back detection region LB and the setting reference value 41 corresponding to the left back detection region LB. When this difference is equal to or less than the threshold value 43 corresponding to the left back detection region LB, the update unit 34 determines that the left back detection region LB is a non-contact region where no conductor is in contact (S161: Y).

The update unit 34 adopts and updates the capacitance equivalent value of the left back detection region LB as the setting reference value 41 of the left back detection region LB for the left back detection region LB determined to be a non-contact region (S162). Thereby, the update process for the left back detection region LB is completed.

In S161, when the difference from the setting reference value 41 corresponding to the left back detection region LB exceeds the threshold value 43 corresponding to the left back detection region LB, the update unit 34 determines that the left back detection region LB is not a non-contact region (S161: N). That is, the update unit 34 determines the left back detection region LB as a contact region where a conductor is in contact. The update unit 34 does not update the setting reference value 41 corresponding to the left back detection region LB (S163). Thereby, the update process for the left back detection region LB is completed.

### (C) Update process for RF

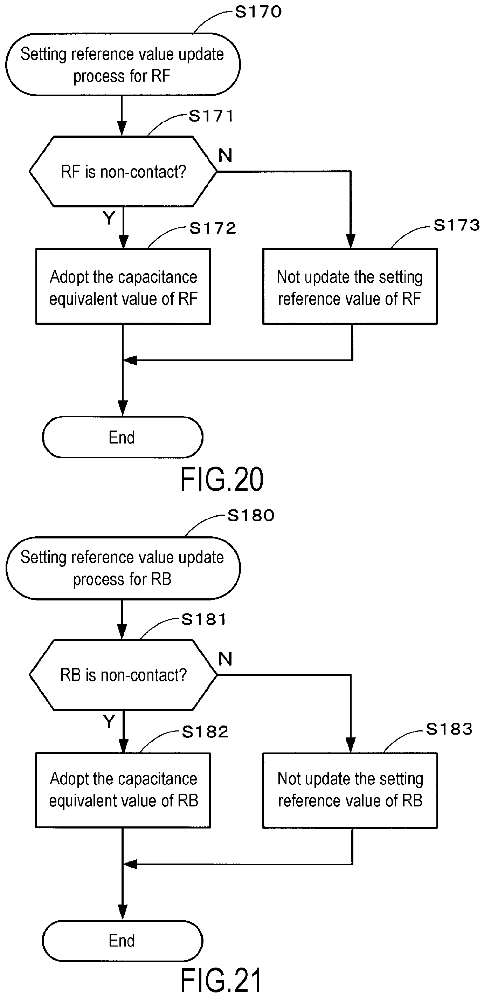

Next, FIG. 20 shows a flowchart of the update process for the right front detection region RF. When the update process for the right front detection region RF is performed (S170), the update unit 34 determines whether the right front detection region RF is a non-contact region (S171). The update unit 34 calculates the difference between the capacitance equivalent value of the right front detection region RF and the setting reference value 41 corresponding to the right front detection region RF. When this difference is equal to or less than the threshold value 43 corresponding to the right front detection region RF, the update unit 34 determines that the right front detection region RF is a non-contact region where no conductor is in contact (S171: Y).

The update unit 34 adopts and updates the capacitance equivalent value of the right front detection region RF as the setting reference value 41 of the right front detection region RF for the right front detection region RF determined to be a non-contact region (S172). Thereby, the update process for the right front detection region RF is completed.

In S171, when the difference from the setting reference value 41 corresponding to the right front detection region RF exceeds the threshold value 43 corresponding to the right front detection region RF, the update unit 34 determines that the right front detection region RF is not a non-contact region (S171: N). That is, the update unit 34 determines the right front detection region RF as a contact region where a conductor is in contact. The update unit 34 does not update the setting reference value 41 corresponding to the right front detection region RF (S173). Thereby, the update process for the right front detection region RF is completed.

### (D) Update process for RB

Next, FIG. 21 shows a flowchart of the update process for the right back detection region RB. When the update process for the right back detection region RB is performed (S180), the update unit 34 determines whether the right back detection region RB is a non-contact region (S181). The update unit 34 calculates the difference between the capacitance equivalent value of the right back detection region RB and the setting reference value 41 corresponding to the right back detection region RB. When this difference is equal to or less than the threshold value 43 corresponding to the right back detection region RB, the update unit 34 determines that the right back detection region RB is a non-contact region where no conductor is in contact (S181: Y).

The update unit 34 adopts and updates the capacitance equivalent value of the right back detection region RB as the setting reference value 41 of the right back detection region RB for the right back detection region RB determined to be a non-contact region (S182). Thereby, the update process for the right back detection region RB is completed.

In S181, when the difference from the setting reference value 41 corresponding to the right back detection region RB exceeds the threshold value 43 corresponding to the right back detection region RB, the update unit 34 determines that the right back detection region RB is not a non-contact region (S181: N). That is, the update unit 34 determines the right back detection region RB as a contact region where a conductor is in contact. The update unit 34 does not update the setting reference value 41 corresponding to the right back detection region RB (S183). Thereby, the update process for the right back detection region RB is completed.

### 5. Effects of the embodiment

Next, the effects of this embodiment will be described. According to this embodiment, when the initial process S1 is performed, the setting reference value 41 corresponding to a non-contact region is set as the determination reference value 42 of a contact region even if there is a conductor in contact with the detection regions LF, RF, LB, and RB. Thus, even if a conductor is in contact with the detection regions LF, RF, LB, and RB, the contact of the conductor can be accurately detected.

Further, according to this embodiment, in the case where all of the plurality of detection regions LF, RF, LB, and RB are contact regions, the setting reference value 41 corresponding to the contact region is set as the determination reference value 42 for the contact region. Thus, even if a conductor is in contact with all of the detection regions LF, RF, LB, and RB, the contact of the conductor can be accurately detected.

Further, according to this embodiment, when determining that a non-contact region exists, the determination reference value setting unit 32 sets the capacitance equivalent value corresponding to the non-contact region detected in the initial process S1 or a value based on the capacitance equivalent value as the setting reference value 41 for the non-contact region. Thus, even if the capacitance equivalent values of the detection regions LF, RF, LB, and RB in a state where no conductor is in contact change due to environmental changes or deterioration over time, the contact of a conductor can be detected accurately.

According to this embodiment, in the case where a plurality of non-contact regions exist, the initial reference value of the non-contact region is set according to the setting source priority order 44, so an appropriate initial reference value can be set depending on the individual condition of the non-contact region.

In addition, when one target detection region 51 is selected from the plurality of detection regions LF, RF, LB, and RB and the target detection region 51 is determined to be a contact region, the possibility that a conductive hand or finger is in contact with the detection regions LF, RF, LB, and RB adjacent to the target detection region 51 in the first direction is considered to be lower than the possibility for the detection regions LF, RF, LB, and RB adjacent to the detection region in the second direction. According to this embodiment, since the setting source detection region 52 adjacent to the target detection region 51 in the first direction is set as the first priority, the time for selecting one of the plurality of setting source detection regions 52 can be shortened.

In addition, when one target detection region 51 is selected from the plurality of detection regions LF, RF, LB, and RB and the target detection region 51 is determined to be a contact region, the possibility that a conductive hand or finger is in contact with the detection regions LF, RF, LB, and RB diagonally positioned with respect to the target detection region 51 is considered to be lower than the possibility for the detection regions LF, RF, LB, and RB adjacent to the detection regions LF, RF, LB, and RB in the second direction. According to this embodiment, since the setting source detection region 52 diagonally positioned with respect to the target detection region 51 is set as the second priority, the time for selecting one of the plurality of setting source detection regions 52 can be shortened.

Further, according to this embodiment, for the four detection regions LF, RF, LB, and RB, the interval between adjacent detection regions LF, RF, LB, and RB in the first direction is larger than the interval between adjacent detection regions LF, RF, LB, and RB in the second direction. Therefore, according to this embodiment, the time for selecting one of the plurality of setting source detection regions 52 can be shortened.

Further, according to this embodiment, the determination processor 30 further includes the update unit 34 that updates the setting reference value 41 to the capacitance equivalent value or a value based on the capacitance equivalent value when determining a non-contact region where no conductor is in contact by comparing the capacitance equivalent value and the setting reference value 41 in each of the plurality of detection regions LF, RF, LB, and RB.

According to this embodiment, the setting reference value 41 is updated to the capacitance equivalent value or a value based on the capacitance equivalent value at a predetermined period. Therefore, for each of the plurality of detection regions LF, RF, LB, and RB, it is possible to deal with deterioration due to changes over time that are specific to the detection regions LF, RF, LB, and RB. As a result, the accuracy of detecting contact with a conductor can be improved.

### (Second embodiment)

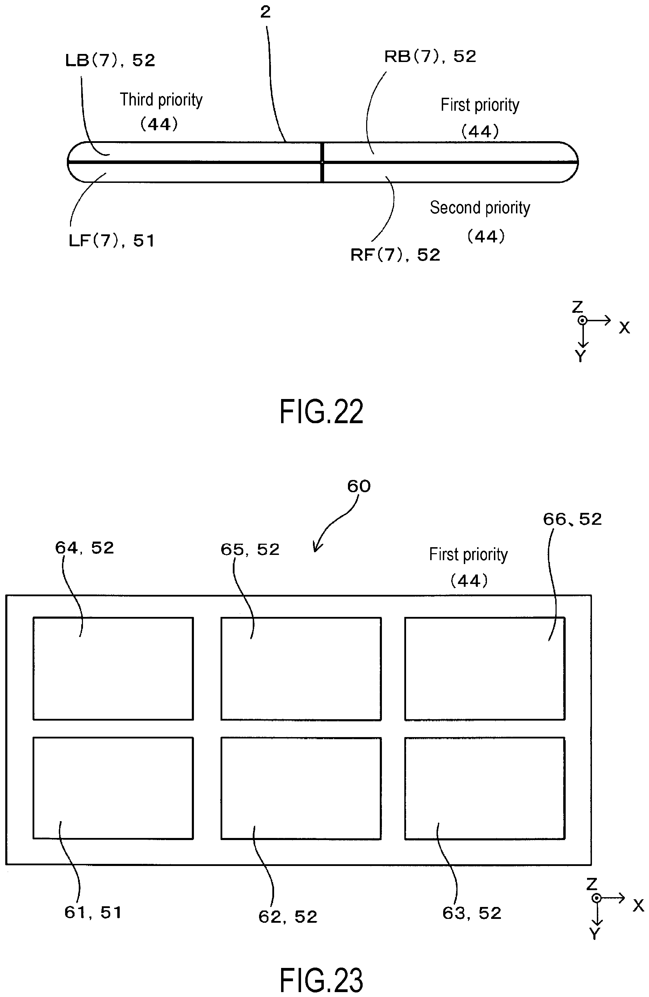

Next, the second embodiment will be described with reference to FIG. 22. FIG. 22 shows the setting source priority order 44 of the setting source detection region 52 when the left front detection region LF is set as the target detection region 51. In this embodiment, the right back detection region RB diagonally positioned with respect to the left front detection region LF is set as the first priority. In other words, the right back detection region RB, which is located on the opposite side to the left front detection region LF in the left-right direction and the front-back direction, is set as the first priority.

In addition, the second priority is set to the right front detection region RF located on the opposite side to the left front detection region LF in the left-right direction. The third priority is set to the left back detection region LB located on the opposite side to the left front detection region LF in the front-back direction.

In addition, among the reference numerals used in the second and subsequent embodiments, the same reference numerals as those used in the previous embodiment represent the same components as those in the previous embodiment, unless otherwise specified.

According to this embodiment, when one target detection region 51 is selected from the plurality of detection regions LF, RF, LB, and RB and the target detection region 51 is determined to be a contact region (in this embodiment, the left front detection region LF), the possibility that a conductive hand or finger is in contact with the detection region (in this embodiment, the right back detection region RB) located on the opposite side to the target detection region 51 in the left-right direction and the front-back direction is considered to be lower than the possibility for the detection region (the right back detection region RB) located on the opposite side to the detection region (the left front detection region LF) in the front-back direction. According to this embodiment, the time for selecting one of the plurality of setting source detection regions 52 in accordance with the setting source priority order 44 can be shortened.

### (Third embodiment)

Next, the third embodiment will be described with reference to FIG. 23. In this embodiment, the direction indicated by arrow Y is the front. The electrostatic sensor 60 according to this embodiment is formed in a sheet shape that is rectangular when viewed from above. A plurality of (six in this embodiment) rectangular detection regions 61 to 66 are disposed on the upper or lower surface of the electrostatic sensor 60. However, the number of detection regions 61 to 66 disposed in one electrostatic sensor 60 is not particularly limited, and may be two to five, or seven or more. Furthermore, the shapes of the electrostatic sensor 60 and the detection regions 61 to 66 are not limited to a rectangular shape, but may be any shape.

The detection regions 61 to 66 include a left front detection region 61 located on the left front side of the electrostatic sensor 7, a central front detection region 62 located on the central front side, a right front detection region 63 located on the right front side, a left back detection region 64 located on the left back side, a central back detection region 65 located on the central back side, and a right back detection region 66 located on the right back side.

FIG. 23 shows the position of the first priority in the setting source priority order 44 of the setting source detection regions 52 when the left front detection region 61 is set as the target detection region 51. In this embodiment, the right back detection region 66 is set as the first priority. The left front detection region 61, which is the target detection region 51, and the right back detection region 66 are not adjacent to each other in the left-right direction or the front-back direction. In addition, the right back detection region 66 is disposed at a position farthest from the left front detection region 61.

In this embodiment, the setting source priority order 44 is set so that the setting source detection region 52 that is not adjacent to the target detection region 51 is given a higher priority than the setting source detection region 52 that is adjacent to the target detection region 51.

When the target detection region 51 at a position is selected from the plurality of detection regions 61 to 66 and the target detection region 51 is determined to be a contact region, the possibility that a conductive hand or finger is in contact with the detection regions 61 to 66 that are not adjacent to the target detection region 51 is considered to be lower than the possibility for the detection regions 61 to 66 that are adjacent to the detection regions 61 to 66. According to this embodiment, since the setting source detection region 52 that is not adjacent to the target detection region 51 is set to a higher priority than the setting source detection region 52 that is adjacent to the target detection region 51, the time for selecting one of the plurality of setting source detection regions 52 can be shortened.

Furthermore, in this embodiment, the electrostatic sensor 60 has three or more detection regions 61 to 66, and the setting source priority order 44 is set so that the setting source detection region 52 farthest from the target detection region 51, among two or more other setting source detection regions 52 different from the target detection region 51, is set as the first priority.

According to this embodiment, the setting source detection region 52 that is farthest from the target detection region 51 is selected as the setting source for the initial reference value of the contact region. Thereby, the time for selecting one of the plurality of setting source detection regions 52 can be shortened.

The present invention is not limited to the above-described embodiments, and can be applied to various embodiments without departing from the gist of the present invention.

## Claims

1. A contact detection apparatus (10), comprising:
an electrostatic sensor (7, 60) having a plurality of detection regions (LB, LF, RB, RF, 61, 62, 63, 64, 65, 66) with which a conductor comes into contact; and
a determination processor (30) detecting whether the conductor is in contact with the plurality of detection regions based on a capacitance equivalent value of each of the plurality of detection regions detected by the electrostatic sensor,
wherein the determination processor comprises:
a storage unit (31) storing a setting reference value (41) which is a capacitance equivalent value corresponding to a state where the conductor is not in contact with each of the plurality of detection regions, a determination reference value (42) of each of the plurality of detection regions, and a threshold value (43) commonly or individually associated with each of the plurality of detection regions;
a determination reference value setting unit (32) setting the determination reference value of each of the plurality of detection regions by an initial process that is performed after the contact detection apparatus is started; and
a determination processing unit (33) detecting whether the conductor is in contact by comparing the capacitance equivalent value with the determination reference value in each of the plurality of detection regions after the initial process,
wherein the determination reference value setting unit
determines a detection region in which a difference between the capacitance equivalent value and the setting reference value exceeds the threshold value among the plurality of detection regions as a contact region with which the conductor is in contact,
determines a detection region in which the difference between the capacitance equivalent value and the setting reference value is equal to or less than the threshold value among the plurality of detection regions as a non-contact region with which the conductor is not in contact, and
sets the setting reference value corresponding to the non-contact region as the determination reference value of the contact region for the contact region in response to determining that the contact region exists and determining that the non-contact region exists.

2. The contact detection apparatus according to claim 1, wherein the determination reference value setting unit sets the setting reference value corresponding to the contact region as the determination reference value for the contact region in response to determining that all of the plurality of detection regions are the contact regions.

3. The contact detection apparatus according to claim 1, wherein the determination reference value setting unit sets the capacitance equivalent value corresponding to the non-contact region detected by the initial process or a value based on the capacitance equivalent value as the setting reference value for the non-contact region in response to determining that the non-contact region exists.

4. The contact detection apparatus according to claim 1, wherein a setting target of the determination reference value among the plurality of detection regions is set as a target detection region, and detection regions different from the target detection region among the plurality of detection regions are set as a plurality of setting source detection regions that are setting sources of the determination reference value for the target detection region,
the storage unit further stores a setting source priority order of the plurality of setting source detection regions, and
in response to determining that a plurality of the non-contact regions exist and determining that the contact region exists, the determination reference value setting unit selects the non-contact region that is the setting source of the determination reference value for the contact region from the plurality of non-contact regions based on the setting source priority order.

5. The contact detection apparatus according to claim 4, wherein the determination reference value setting unit determines whether the plurality of setting source detection regions are the contact region or the non-contact region according to the setting source priority order, and
selects the non-contact region that is the setting source of the determination reference value for the contact region from the plurality of setting source detection regions.

6. The contact detection apparatus according to claim 4 or 5, wherein the setting source priority order is set to a different order in each of the plurality of detection regions.

7. The contact detection apparatus according to claim 5, wherein the electrostatic sensor has four detection regions arranged to be spaced apart in a first direction of a long side and arranged to be spaced apart in a second direction of a short side perpendicular to the first direction, and
the setting source priority order is set so that a position adjacent in the first direction is given a first priority.

8. The contact detection apparatus according to claim 7, wherein the electrostatic sensor has four detection regions arranged to be spaced apart in a first direction of a long side and arranged to be spaced apart in a second direction of a short side perpendicular to the first direction, and
the setting source priority order is set so that a diagonal position is given a second priority.

9. The contact detection apparatus according to claim 7 or 8, wherein for the four detection regions, an interval between the detection regions adjacent in the first direction is larger than an interval between the detection regions adjacent in the second direction.

10. The contact detection apparatus according to claim 5, wherein the electrostatic sensor has four detection regions arranged to be spaced apart in a first direction and arranged to be spaced apart in a second direction perpendicular to the first direction, and
the setting source priority order is set so that a diagonal position is given a first priority.

11. The contact detection apparatus according to claim 5, wherein the electrostatic sensor is a sensor for a steering wheel (1) of a vehicle,
the electrostatic sensor has four detection regions located on a left front surface, a right front surface, a left back surface, and a right back surface as viewed from a driver of the vehicle, and
the setting source priority order is set so that a position on an opposite side in a left-right direction is given a first priority.

12. The contact detection apparatus according to claim 11, wherein the setting source priority order is set so that a position on an opposite side in a left-right direction and on the same side in a front-back direction is given a first priority.

13. The contact detection apparatus according to claim 11, wherein the setting source priority order is set so that a position on an opposite side in a left-right direction and on an opposite side in a front-back direction is given a first priority.

14. The contact detection apparatus according to claim 4, wherein the setting source priority order is set so that the setting source detection region that is not adjacent to the target detection region is set to a higher priority than the setting source detection region that is adjacent to the target detection region.

15. The contact detection apparatus according to claim 14, wherein the electrostatic sensor has three or more detection regions, and
the setting source priority order is set so that the setting source detection region farthest from the target detection region, among two or more other setting source detection regions different from the target detection region, is set as a first priority.

16. The contact detection apparatus according to claim 1, wherein the determination processor further comprises an update unit (34) updating the setting reference value to the capacitance equivalent value or a value based on the capacitance equivalent value in response to determining a non-contact region with which the conductor is not in contact by comparing the capacitance equivalent value with the setting reference value in each of the plurality of detection regions.
